# EUROPEAN PATENT SPECIFICATION

(11) **EP 0 275 171 B1**
(45) Date of publication and mention of the grant of the patent: **22.03.1995**
(21) Application number: 88300197.6
(22) Date of filing: 12.01.1988
(51) Int. Cl.: H05K 9/00

(54) **A gasket for E.M.I. shielding and for sealing**
Elektromagnetische Interferenz-Abschirmung und Dichtung
Joint de blindage contre les interférences électromagnétiques et d'étanchéité

(30) Priority: 13.01.1987 US 2827
(43) Date of publication of application: 20.07.1988
(73) Proprietor: RAYCHEM CORPORATION (a California corporation), Menlo Park California 94025 (US)
(72) Inventor: Dubrow, Robert S., Redwood City California 94306 (US); Chan, Randolph W., Palo Alto California 94306 (US); Holland, Christine J., San Mateo California 94430 (US)
(74) Representative: Dlugosz, A.C.

(56) References cited:
- EP-A- 0 059 063
- EP-A- 0 167 905
- GB-A- 2 127 979
- GB-A- 2 129 831
- US-A- 2 885 459
- US-A- 3 019 281
- US-A- 3 026 367
- US-A- 3 126 440
- US-A- 3 431 348
- US-A- 3 542 939
- US-A- 3 583 930
- US-A- 3 708 871
- US-A- 4 037 009
- US-A- 4 459 470
- US-A- 4 631 214

## Description

This invention relates to gaskets for electromagnetic energy interference (E.M.I.) shielding and for environmentally sealing the space between two surfaces.

E.M.I. shielding is for providing protection against interference from electromagnetic energy, including radio frequency interference (R.F.I.), which protection may be to protect an electronic device from external E.M.I. and R.F.I. or may be to prevent E.M.I. or R.F.I. from escaping from an electrical device, or both. Environmental sealing is for protection against moisture, corrosion, dust, insects and similar environmental contamination encountered by electrical or electronic devices when in service.

E.M.I. gaskets and seals have been made from the combination of rubber or elastomeric materials and wires or metal filaments. These gaskets are intended to function by the wires contacting the surfaces between which the gasket is assembled to provide the E.M.I. shielding and the rubber or elastomeric material is intended to provide the environmental seal when compressed between the intended surfaces. Examples of such gaskets are disclosed in US-A-4037009, in U.S. patents 2,885,459 to Pulsifer et al.; 3,019,281 and 3,026,367 to Hartwell; 3,126,440 to Goodloe; 3,431,348 to Nellis et al.; 3,542,939 to Mintz; 3,566,064 to Nellis; and 3,708,871 to Mintz.

In another form, E.M.I. gaskets have been provided in the form of a plastic binder containing electrically conductive particles, such as aluminum, coated with silver. Examples of this type of gasket are disclosed in U.S. patents 3,583,930 to Ehrreich et al. and 4,434,541 and 4,507,359 to Powers.

In another form, E.M.I. gaskets have been provided with a flexible foam rubber core having a wire exterior cover on the foam core such as a knitted or braided or otherwise woven wire fabric cover. The foam rubber core is intended to provide resilience to assure that the wire cover makes good electrical contact when compressed between the intended surfaces and is also intended to provide an environmental seal between the intended surfaces.

It has been found that the above gaskets exhibit a number of problems in actual use, including corrosion or rusting of the metallic or wire portion and failure of the plastic, rubber, elastomer or foam to provide the desired environmental seal. In an attempt to eliminate corrosion, some gaskets have been made of noble metal wires, such as silver, which adds significantly to the cost of the gasket and does not always solve the corrosion and oxidation problems. In some of the above gaskets, a moisture leak path exists where the wires contact the surfaces because the rubber, elastomer or foam material does not adequately seal around and between the wires or metallic structures and the surfaces to prevent migration of moisture into or through the gasket area. Any migration of moisture into or through the gasket area frequently causes corrosion of the metal in the gasket and corrosion or other problems in the electrical or electronic device being protected by the gasket.

It has been recognized in the art that the above gaskets do not fulfill the desired functions. Frequently when the gaskets provide satisfactory E.M.I. shield, they do not provide the desired environmental sealing and/or the gasket itself has corrosion problems. Alternatively when the gaskets provide adequate environmental sealing, they frequently do not provide the desired E.M.I. shielding. Consequently, it has also been recognized in the art that in many cases it has been necessary to separate the two functions and have an exterior conventional environmental gasket, such as an elastomeric or rubber O-ring, and a separate interior E.M.I. gasket, such as a wire mesh. This arrangement is undesirable, however, because it takes extra space, requires extra design, engineering and machining and increases installation difficulties, costs and risks of improper installation.

In view of the above, this invention seeks to provide an E.M.I. gasket which provides electrical shielding and provides environmental sealing for not only the space between two surfaces but also for the metallic components which provide the electrical shielding in the gasket.

Accordingly, in one aspect, this invention provides a gasket for electrically shielding against E.M.I. and environmentally sealing the space between two surfaces the gasket comprising an electrically conductive deformable metallic component for providing electrical shielding in the space between said surfaces; wherein the metallic component is adapted for contact with said surfaces and the gasket further comprises a gel material for sealing the space between said surfaces having a cone penetration value of about 100 to 350 (10⁻¹mm) and an ultimate elongation of at least 200% and being present in sufficient amount and positioned to provide an environmental seal between the said surfaces and to provide environmental protection of the said conductive component, the gel material covering the metallic component and the metallic component is adapted and positioned such that portions thereof pierce through the gel material and contact the surfaces when the gasket is compressed between the surfaces.

In another aspect, this invention provides a method of providing E.M.I. shielding and an environmental seal between two surfaces by positioning a gasket as claimed in claim 1 between the two surfaces and compressing said gasket between said surfaces to deform the gel material and to establish electrical contact between the electrically conductive component and the surfaces.

In another aspect, the invention provides an assembly comprising two surfaces and a gasket as claimed in claim 1 compressed between said surfaces.

The component may be formed as, for example, a woven or non-woven, braided or knitted fabric as a wire bristle structure such as the structure of a pipe cleaner or bottle brush where the wires are radially oriented, or it may be formed as an expanded metal mesh. Other suitable structures which will form electrical contact between the surfaces and provide the desired electrical shielding properties will be apparent to those skilled in the art. A woven structure may be in the form of a circular or flat knit fabric which has good flexibility and conformability and provides good electrical shielding.

The gel material useful in the present invention may be any composition or material having the physical properties of a cone penetration value from about 100 to about 350 (10⁻¹mm) as measured by ASTM D-937-77, and an ultimate elongation of at least 200%, as determined by ASTM D-412. Such gel materials may be, for example, polyurethane, silicone, polyolefinic block copolymers and other compositions which have the above cone penetration and elongation properties necessary for the gel material to have high conformability under low compression forces to provide the environmental sealing of the surfaces between which the gasket is compressed. Such gel materials have been used to protect substrates from corrosion and to provide electrical insulation on certain electrical terminals and connectors to prevent electrical malfunction upon exposure to moisture. For example, such gel materials have been used in various applications as disclosed in EP-A-108,518, EP-A-196219, EP-A-0191609, EP-A-0194872, EP-A-0204427 and EP-A-0200557. Examples of suitable gel compositions and materials are also shown in EP-A-203738 and EP-A-0224389, and in International Patent Aoplication No. PCT/GB87/00506.

The gels useful in the present invention in general have a cone penetration value from about 100 to about 350 (10⁻¹mm). In many uses it is preferred that the gel have a cone penetration between about 150 and about 350 (10⁻¹mm) and in some applications it is preferred that the cone penetration be between about 100 and about 300 (10⁻¹mm). The gels when used in relatively thin layers with appropriate covering layer may provide superior surface protection and sealing when the cone penetration is between about 250 and about 350 (10⁻¹mm). The ultimate elongation of the gel material should be at least 100% in order to provide good conformability with the surface of the substrate. Higher values are generally preferred in order to provide better sealing of the gel material to the surface of the substrate. It is generally preferred that the gel material have an elongation of at least 200% and in many applications an elongation of at least 500% is desired. In other applications it is preferred that the gel material have an elongation of at least 750%.

The gaskets of the present invention may be formed in flat shapes such as flat woven or knitted wire fabric or circular knitted or tubular braided structures. Such circular or tubular structures can also be flattened if a flat shape is desired. In general, lower compression forces may be used with the round gaskets to obtain the desired electrical shielding and environmental sealing with the gaskets of this invention. For example, a pressure in a range of about 6894,7 Pa to about 689,47 Pa (1 to about 10 psi) is generally sufficient with round gaskets while the flat gaskets according to this invention may require pressure obtained in the range of about 34,473 kPa to about 172,367 kPa (5 to about 25 psi). Higher pressures can be used, but are not required. These pressures and forces are significantly lower than is typically required with the prior art rubber, foam and elastomeric gaskets and substantially lower than required with the particle filled plastic E.M.I. gaskets. Thus, the gaskets according to the present invention have the advantage that they are easy to install and the desired E.M.I. shielding and environmental sealing can be obtained with low compressive forces, thus making the gaskets of the present invention suitable for use on lighter weight devices and construction materials.

The gaskets of the present invention also have the advantage that they are able to provide corrosion resistance because the gel material in the gaskets of the present invention is able to encapsulate and to protect not only the surfaces which are being sealed but also protects the metal structure of the gasket itself from environmental effects such as moisture or chemical exposure. Another advantageous feature of the gaskets of the present invention is that even if some portion of the electrically conductive component of the gasket is exposed to the environment, and corrodes up to the surface of the gel part of the gasket, the rust or corrosion will be halted at that point. The gasket as it is compressed and installed between the surfaces will continue to provide environmental sealing and electrical shielding provided that a sufficient amount of the component is embedded within the gel and protected by the gel from further corrosion.

The gaskets of the present invention can be made by any convenient method similar to the methods used in the above referenced copending applications for manufacturing tape and other structures containing gel or having gel as a component thereof. For example, the conductive component can be filled with the liquid uncured gel material which is then cured in place within the component to completely encapsulate the component. Alternatively, the gaskets according to the present invention can be made by laminating the precured layer of gel with the component in one or more layers to provide sufficient gel material for the component. For example, an expanded metal mesh component may have a layer of precured gel laminated on one or both sides thereof. In another example, a sheet of precured gel having sufficient thickness could have two sheets of expanded metal mesh laminated to the two sides of the gel sheet. In another example, a round gel rope can be fed through a braider or circular knitter and a wire structure braided or knitted on the exterior surface of the gel. In yet another example, a tubular braided metal wire structure or circular knitted metal wire structure could be filled with the liquid uncured gel and the gel allowed to cure inside the braided or knitted wire structure such that the gel encapsulates or coats the entire knitted or braided wire structure. Other methods of making the gaskets of the present invention will be apparent to one skilled in the art following the teachings of this specification.

The description of the present invention is in the context of shielding and sealing the space between two surfaces. However, it is to be understood that the scope of the gaskets and methods of the present invention includes the shielding and sealing the space between three, four or more surfaces. It will be readily apparent to one skilled in the art that the gaskets of this invention can easily be designed and shaped to be effective to seal the space where three or more surfaces come together. Therefore in this application the language "two surfaces" includes at least two or two or more surfaces within the scope thereof.

Embodiments of the gasket and the method according to the invention will now be described by way of example with reference to the accompanying drawings, in which:
Figures 1a, 1b and 1c show a gasket of the present invention wherein the electricall conductive component is contained within the gel material, and Figure 1d shows the gasket installed between two surfaces;
Figure 2a shows a gasket for explanatory reasons wherein a portion of the electrically conductive component is outside the gel material, and Figure 2b shows such a gasket installed between two surfaces;
Figure 3 is a graph of frequency versus signal attenuation to show the shielding effectiveness of the woven wire cloth shown in Figures 1a and 1b, measured as described below;
Figure 4 shows the shielding effectiveness of the gasket illustrated in Figure 1c;
Figure 5 shows the shielding effectiveness of a knitted wire strap;
Figure 6 shows the shielding effectiveness of a gasket according to this invention made from a kitted wire strap; and
Figure 7 is a graph showing how the resistivity of an electrical connection changes when sprayed with a salt solution, as described below.

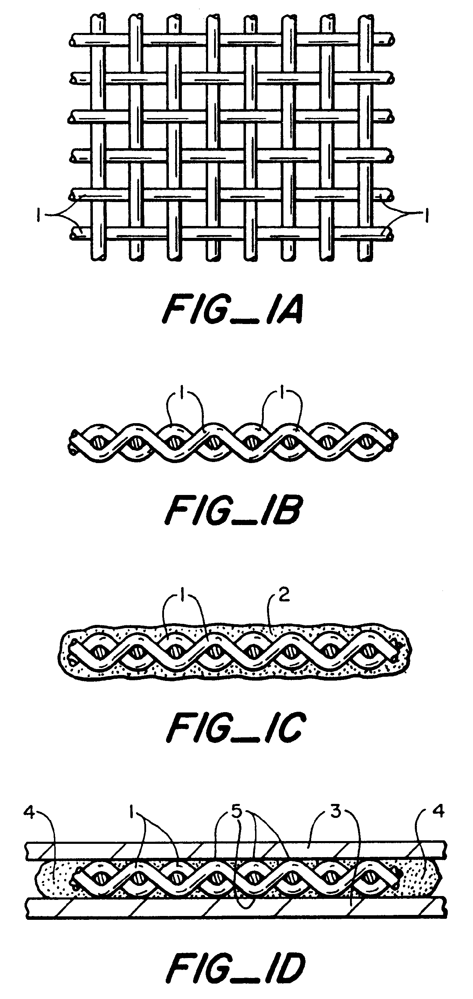

Referring to the drawings, Figures 1a and 1b show a fabric which is woven from wires 1. As shown in Figure 1c, the woven metal fabric containing wires 1 is encapsulated in the cured gel 2. In Figure 1d the gasket of Figure 1c is installed and compressed between surfaces 3. Due to the compression, metal wires 1 contact the surfaces 3 at points 5 and the gel has been compressed and expanded into areas 4. As can be seen in Figure 1d, the gel environmentally seals between surfaces 3 and encapsulates and environmentally protects the woven metal fabric formed from wires 1.

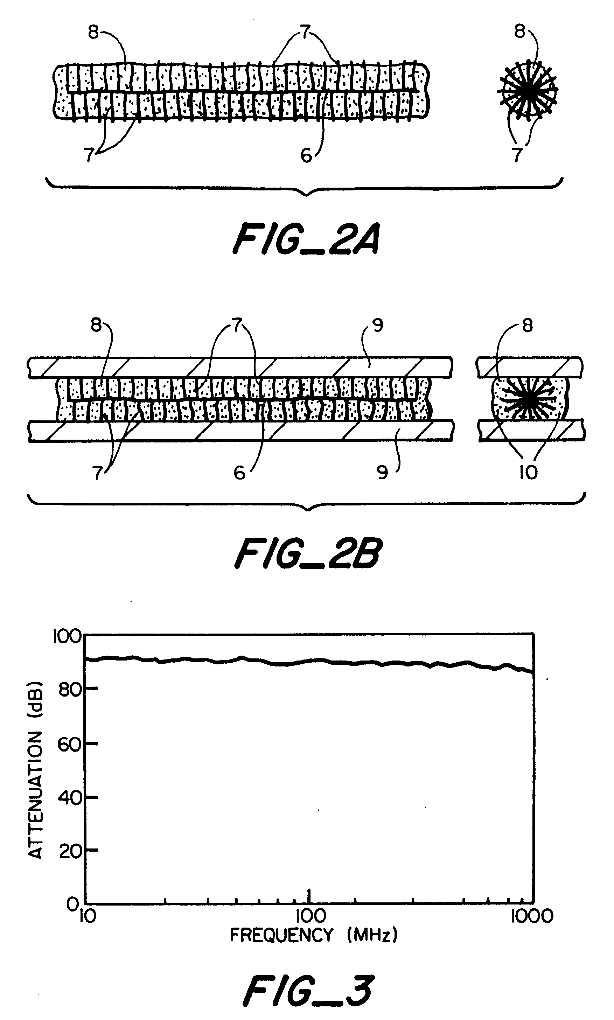

Figure 2a shows for explanatory reasons a side view and end view of a gasket constructed from a wire pipe cleaner or bottle brush type structure comprising center wire 6 and radial wires 7 which extend beyond the surface of the gel layer 8 within the wire structure. Figure 2b shows a side view and end view of the gasket of Figure 2a installed and compressed between surfaces 9. As can be seen in Figure 2b wires 7 are in contact with surfaces 9 and the gel has been deformed and expanded into areas 10 where the gel has encapsulated and covered the ends of wires 7 which are not in direct contact with surfaces 9.

Gaskets in accordance with the present invention are further described with reference to the following examples.

### Example 1

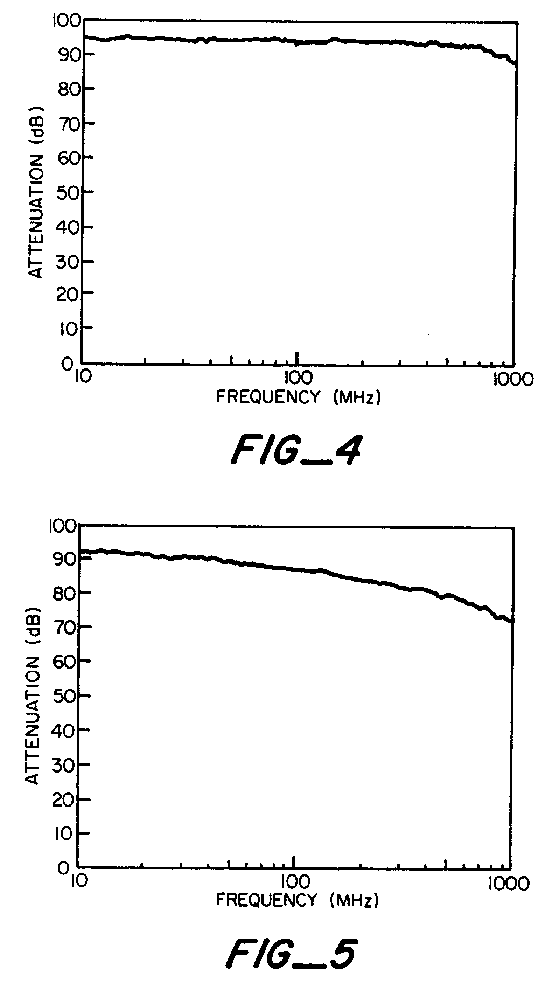

The ability of a woven wire cloth such as shown in Figure 1 to attenuate across a 3.8 mm gap at frequencies between 10MHz and 1GHz was measured using the transfer impedance method called out in Society of Automotive Engineers SAE-ARP-1705 specification. The scan across the frequency range is illustrated in Figure 3. It can be seen in this figure that the attenuation is in excess of 90dB.

### Example 2

The wire cloth described in Figure 1 was impregnated with a polydimethylsiloxane gel having a cone penetration of 260 (10⁻¹mm) and an elongation of 450 percent. A frequency versus attenuation scan was run on the impregnated cloth under conditions identical to those in Example 1. The resulting data is shown in Figure 4. It can be seen in this figure that the scan is indistinguishable from Figure 2 and thus shows the ability of the wire cloth to cut through the gel and make contact with the metal substrates when compressed in the test fixture.

### Example 3

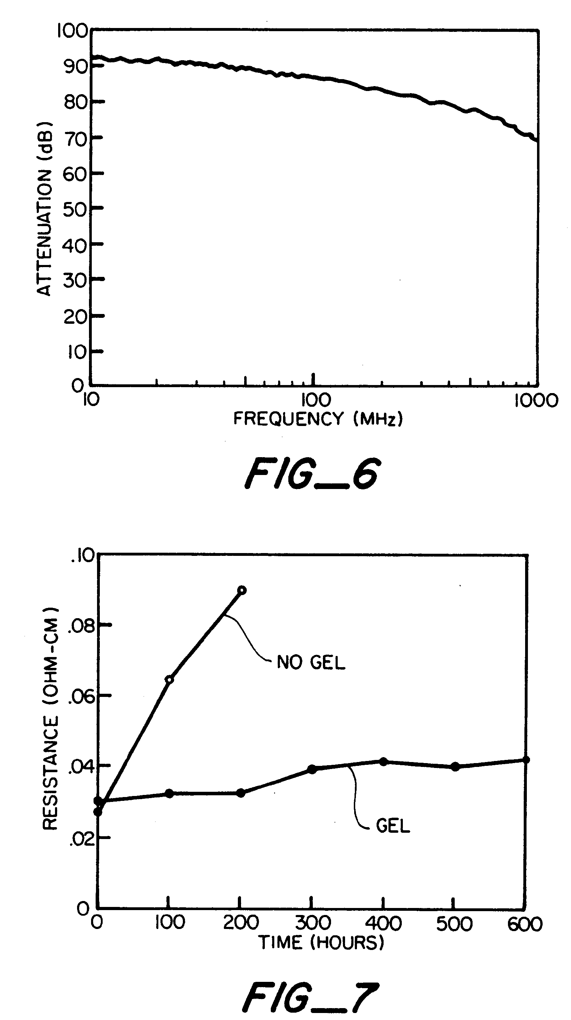

A 4 mm diameter knitted wire strip made from 115 micrometer Monel wire was measured for its ability to attenuate electromagnetic frequencies using the same technique outlined in the two previous examples. The scan can be found in Figure 5.

### Example 4

The strip described in Example 3 was impregnated with polydimethylsiloxane of cone penetration 260 (10⁻¹mm) and elongation of 450 percent and then measured for shielding capabilities as described in the previous example. The scan is found in Figure 6 and is almost identical to the unimpregnated version found in Figure 5.

### Example 5

Corrosion testing of the woven wire cloth without gel impregnation described in Example 1 and of the gel gasket described in Example 2 was performed. Doughnut shaped specimens were punched out having a 44.5 mm outside diameter and a 31.75 mm inside diameter. The specimens were clamped between aluminum disks and exposed to salt spray in accordance with military standard Mil-STD-810. Resistivity changes were measured every 100 hours on the assemblies up to five hundred hours. Figure 7 shows the changes for the impregnated and unimpregnated wire cloth. It can be seen that the conductivity of the joint is protected by the gel.

## Claims

1. A gasket (1c) for electrically shielding against E.M.I. and environmentally sealing the space between two surfaces (3) the gasket (1c) comprising an electrically conductive deformable metallic component (1) for providing electrical shielding in the space between said surfaces; wherein the metallic component is adapted for contact with said surfaces (3) and the gasket further comprises a gel material (2) for sealing the space between said surfaces having a cone penetration value of about 100 to 350 (10⁻¹mm) and an ultimate elongation of at least 200% and being present in sufficient amount and positioned to provide an environmental seal between the said surfaces and to provide environmental protection of the said conductive component, the gel material (2) covering the metallic component (1) and the metallic component (1) is adapted and positioned such that portions thereof pierce through the gel material (2) and contact the surfaces (3) when the gasket is compressed between the surfaces.

2. A method of providing E.M.I. shielding and an environmental seal between two surfaces by positioning a gasket as claimed in claim 1 between said two surfaces and compressing said gasket between said surfaces to deform the gel material and to establish electrical contact between the conductive component and said surfaces.

3. An assembly comprising two surfaces (3) and a gasket (1c) as claimed in claim 1 compressed between said surfaces.

## Patentansprüche

1. Dichtung (1c), um den Raum zwischen zwei Oberflächen (3) gegen elektromagnetische Beeinflussung bzw. EMB elektrisch abzuschirmen und gegenüber der Umgebung abzudichten, wobei die Dichtung (1c) eine elektrisch leitfähige verformbare metallische Komponente (1) aufweist, um die elektrische Abschirmung in dem Raum zwischen den Oberflächen zu bilden; wobei die metallische Komponente zum Kontakt mit den Oberflächen (3) ausgebildet ist und die Dichtung ferner ein Gel-material (2) aufweist, um den Raum zwischen den Oberflächen abzudichten, das einen Konuspenetrationswert von ca. 100-350 (10⁻¹ mm) und eine Bruchdehnung von mindestens 200 % hat und in ausreichender Menge anwesend und positioniert ist, um zwischen den genannten Oberflächen eine Abdichtung gegenüber der Umgebung zu bilden und um einen Schutz der genannten leitfähigen Komponente gegenüber der Umgebung zu bilden, wobei das Gelmaterial (2) die metallische Komponente (1) bedeckt und die metallische Komponente (1) so ausgebildet und positioniert ist, daß Bereiche davon durch das Gel-material (2) dringen und mit den Oberflächen (3) in Kontakt gelangen, wenn die Dichtung zwischen den Oberflächen zusammengedrückt wird.

2. Verfahren zum Bilden einer EMB-Abschirmung und einer Abdichtung gegenüber der Umgebung zwischen zwei Oberflächen durch Positionieren einer Dichtung nach Anspruch 1 zwischen den beiden Oberflächen und Zusammendrücken der Dichtung zwischen diesen Oberflächen, um das Gelmaterial zu verformen und um elektrischen Kontakt zwischen der leitfähigen Komponente und den Oberflächen herzustellen.

3. Anordnung, die zwei Oberflächen (3) und eine Dichtung (1c) nach Anspruch 1 aufweist, die zwischen den Oberflächen zusammengedrückt ist.

## Revendications

1. Joint (1c) pour protéger électriquement par blindage contre les parasites électromagnétiques (E.M.I.) et pour obturer de façon étanche au milieu ambiant l'espace entre deux surfaces (3), le joint (1c) comportant un constituant métallique déformable électriquement conducteur (1) destiné à réaliser un blindage électrique dans l'espace entre lesdites surfaces ; dans lequel le constituant métallique est destiné à un contact avec lesdites surfaces (3) et le joint comporte en outre une matière du type gel (2) destiné à obturer de façon étanche l'espace entre lesdites surfaces et ayant une valeur de pénétration de cône d'environ 100 à 350 (10⁻¹ mm) et un allongement à la rupture d'au moins 200 %, et étant présente en quantité suffisante et positionnée pour former une obturation étanche au milieu ambiant entre lesdites surfaces et pour protéger du milieu ambiant ledit constituant conducteur, la matière du type gel (2) recouvrant le constituant métallique (1), et le constituant métallique (1) est conçu et positionné pour que des parties de ce constituant transperce la matière du type gel (2) et établisse un contact avec les surfaces (3) lorsque le joint est comprimé entre les surfaces.

2. Procédé pour réaliser un blindage contre les parasites électromagnétiques (E.M.I.) et une obturation étanche au milieu ambiant entre deux surfaces en positionnant un joint selon la revendication 1 entre lesdites deux surfaces et en comprimant ledit joint entre lesdites surfaces pour déformer la matière du type gel et établir un contact électrique entre le constituant conducteur et lesdites surfaces.

3. Assemblage comprenant deux surfaces (3) et un joint (1c) selon la revendication 1, comprimé entre lesdites surfaces.
